# EUROPEAN PATENT SPECIFICATION

(11) **EP 4 202 504 B1**
(45) Date of publication and mention of the grant of the patent: **23.07.2025**
(21) Application number: 22155763.0
(22) Date of filing: 09.02.2022
(51) Int. Cl.: H10F 39/00, G02B 5/02

(54) **LIGHT DIFFUSER, IMAGE SENSOR PACKAGE HAVING THE SAME, AND MANUFACTURING METHOD THEREOF**
LICHTDIFFUSOR, BILDSENSORGEHÄUSE DAMIT UND HERSTELLUNGSVERFAHREN DAFÜR
DIFFUSEUR DE LUMIÈRE, BOÎTIER DE CAPTEUR D'IMAGE LE COMPORTANT ET SON PROCÉDÉ DE FABRICATION

(30) Priority: 22.12.2021 US 202117560239
(43) Date of publication of application: 28.06.2023
(73) Proprietor: VisEra Technologies Company Limited, Hsinchu 300-78 (TW)
(72) Inventor: HSU, Chung-Jung, 300 Hsinchu City (TW); HSIEH, Chin-Chuan, 30078 Hsin-Chu City (TW); LIN, Kuo-Feng, 804 Kaohsiung City (TW)
(74) Representative: Berggren Oy

(56) References cited:
- EP-A1- 3 078 905
- EP-A1- 3 514 615
- DE-A1- 102014 107 099
- DE-A1- 102019 123 890
- US-A1- 2010 150 513
- US-A1- 2017 322 349
- US-A1- 2020 025 981

## Description

### BACKGROUND

### Field of Invention

The present disclosure relates to a light diffuser, an image sensor package having the light diffuser, and a manufacturing method of the image sensor package.

### Description of Related Art

In order to capture a color image of a scene, an image sensor should be sensitive to a broad spectrum of light. The image sensor reacts to light that is reflected from the scene and can convert the strength of that light into electronic signals. An image sensor, such as a charge-coupled device (CCD) image sensor or a complementary metal-oxide semiconductor (CMOS) image sensor, generally has photoelectric conversion regions that convert incident light into electronic signals. In addition, the image sensor has logic circuits for transmitting and processing the electronic signals. Image sensors are widely applied in many fields, as well as in devices such as light sensors, proximity sensors, time-of-flight (TOF) cameras, spectrometers, smart sensors used in the Internet of things (TOT), and sensors for advanced driver assistance systems (ADAS), for example.

Although existing image sensor packages have been adequate for their intended purposes, they have not been entirely satisfactory in all respects. For example, the scattering capability of a light diffuser over a photoelectric conversion region remains to be improved.

DE 10 2019 123 890 A1 describes an optical body having a matrix material having a refractive index which is less than or equal to 1.5, a plurality of scattering particles having a refractive index of greater than or equal to 2.0, and a plurality of pores, which are filled with a gas.

US 2017/0322349 A1 describes a diffuse reflection material that includes white scattering particles and an adhesive agent, where the whiteness of the white scattering particles is greater than 85, and the white scattering particles contain high reflection scattering particles with a whiteness of greater than 90, high refraction scattering particles with a refractive index of greater than or equal to 2.0, and high thermal conductivity scattering particles, where the high thermal conductivity scattering particles are boron nitrite and/or aluminum nitride particles, and the particle shape of the high thermal conductivity scattering particles is rod-like or flat.

DE 10 2014 107 099 A1 describes a light-scattering layer system comprising a substrate and a layer located on the substrate with the following components: a first type of inorganic particles having a diameter in the range of 100 nm to 1.2 µm; a second type of particles having a diameter in the range of 2 to 25 nm which are oxide particles obtained by hydrolytic condensation of a solute precursor, wherein one of the two types of particles has a refractive index which, at a defined wavelength, preferably the wavelength of the He spectral line (0.5865 µm), differs by at least 0.17, preferably by at least 0.25 and more preferably by at least 1.0 from the refractive index of the other type at the same wavelength.

US 2020/0025981 A1 describes the optical scattering response of a textured substrate that is altered by the addition of one or more layers of nanoparticles and/or coatings. The nanoparticles and/or coatings have a refractive index that is comparable, or higher, than the refractive index of the substrate. The scattering cross section of the substrate is reduced by partially or completely filling gaps in the substrate.

EP 3514615 A1 describes a photoresist resin composition comprising: a plurality of quantum dots; a photopolymerizable monomer; a photopolymerization initiator; a scatterer; a binder resin; and a solvent, wherein an amount of the scatterer is in a range of about 2 parts to about 20 parts by weight based on 100 parts by weight of a total amount of the photoresist resin composition.

US 2010/0150513 A1 describes a multifunctional optical film including a flexible substrate, a structured layer having nanoparticles of different sizes, and a backfill layer. The structured layer effectively uses microreplicated diffractive or scattering nanostructures located near enough to the light generation region to enable extraction of an evanescent wave from an organic light emitting diode (OLED) device. The backfill layer has a material having an index of refraction different from the index of refraction of the structured layer.

EP 3078905 A1 describes a solid optical sky-sun diffuser including a transparent solid matrix embedding a dispersion of transparent nanoparticles having an average sized in the range 10nm ≤ d ≤ 240nm. The ratio between the blue and red scattering optical densities γ=Log[T(450mn)]/Log[T(630nm)] of the optical diffuser falls in the range 5≥y≥2.5, where T(A) is a monochromatic normalized collinear transmittance of the optical diffuser. Along at least a first propagation direction, the monochromatic normalized collinear transmittance of the optical diffuser is T(450nm) ≥ 0.4. Along at least a second propagation direction, the monochromatic normalized collinear transmittance of the optical diffuser is T(450nm)≤0.9,the second propagation direction being orthogonal to the first propagation direction. Along the second direction the monochromatic collinear transmittance of the optical diffuser is 0.1≤T(λ)≤0.5 for A=570nm.

### SUMMARY

An aspect of the present disclosure is to provide a light diffuser.

According to an embodiment of the present disclosure, a light diffuser is defined by the features of claim 1.

In some embodiments of the present disclosure, a refractive index of the first fillers is higher than a refractive index of the main body.

In some embodiments of the present disclosure, a weight ratio of the first fillers to a combination of the main body and the first fillers is in a range from 10% to 30%.

In some embodiments of the present disclosure, the light diffuser further includes second fillers dispersed in the main body. A refractive index of the second fillers is lower than a refractive index of the first fillers.

In some embodiments of the present disclosure, the refractive index of the second fillers is lower than a refractive index of the main body.

In some embodiments of the present disclosure, the second fillers include SiO₂.

In some embodiments of the present disclosure, a diameter of each of the second fillers is in a range from 1 µm to 10 µm.

In some embodiments of the present disclosure, a weight ratio of the second fillers to a combination of the main body, the first fillers, and the second fillers is in a range from 20% to 50%.

In some embodiments of the present disclosure, the main body is a photoresist layer including epoxy or acrylic resin.

In some embodiments of the present disclosure, there is no TiO₂ located in the main body.

An aspect of the present disclosure is to provide an image sensor package as defined in claim 9.

In some embodiments of the present disclosure, the image sensor package further includes a metal-insulator-metal (MIM) structure between the light diffuser and the semiconductor substrate.

In some embodiments of the present disclosure, the light diffuser is directly on the MIM structure.

In some embodiments of the present disclosure, a refractive index of the first fillers is higher than a refractive index of the main body.

In some embodiments of the present disclosure, the image sensor package further includes second fillers dispersed in the main body. A refractive index of the second fillers is lower than a refractive index of the first fillers and a refractive index of the main body.

In some embodiments of the present disclosure, the second fillers comprise SiO₂.

In some embodiments of the present disclosure, a diameter of each of the second fillers is in a range from 1 µm to 10 µm.

In some embodiments of the present disclosure, a weight ratio of the second fillers to a combination of the main body, the first fillers, and the second fillers is in a range from 20% to 50%.

An aspect of the present disclosure is to provide a manufacturing method of an image sensor package.

According to an embodiment of the present disclosure, a manufacturing method of an image sensor package includes mixing first fillers with a resin to form a solution, wherein the first fillers include at least one of Si, Ge GaP, InP, and PbS, and a diameter of each of the first fillers is in a range from 0.1 µm to 1 µm; dispensing the solution to a semiconductor substrate; spreading the solution to cover the semiconductor substrate by spin coating; and curing the solution to form a light diffuser, wherein the resin is cured to be a main body of the light diffuser.

In some embodiments of the present disclosure, the method further includes prior to dispensing the solution to the semiconductor substrate, mixing second fillers with the resin, wherein a refractive index of the second fillers is lower than a refractive index of the first fillers.

In the aforementioned embodiments of the present disclosure, since the first fillers dispersed in the main body of the light diffuser have high refractive index, and the first fillers include at least one of Si, Ge GaP, InP, and PbS, the light diffuser can have high scattering capability and prevent photolysis. Moreover, the first fillers have low reactivity with organics, and thus the selection of materials for the main body of the light diffuser is more flexible. As a result, the main body with the first fillers may be formed over the semiconductor substrate by spin coating without a compression molding process.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiments, with reference made to the accompanying drawings as follows:
Fig. 1 is a cross-sectional view of an image sensor package according to one embodiment of the present disclosure.
Figs. 2 and 3 are schematic views at various stages of a manufacturing method of the image sensor package of Fig. 1.
Fig. 4 is a schematic view of a light diffuser when light passes through according to one embodiment of the present disclosure.
Fig. 5 is a Transmission rate-Wavelength relationship chart with respect to incident light with different incident angles passing through the light diffuser of the image sensor package of Fig. 1.
Fig. 6 is a Luminous intensity-Viewing angle relationship chart with respect to two light diffusers and one dry film, in which the two light diffusers include different proportions of fillers.
Fig. 7 is a distribution diagram of luminous intensity with respect to the light diffuser including a lower proportion of the fillers of Fig. 6 after light passing through the light diffuser.
Fig. 8 is a partial enlarged view of the light diffuser of Fig. 1.
Fig. 9 is a schematic view for a phase contrast which occurs in the light diffuser of Fig. 8.
Fig. 10 is a partial enlarged view of a light diffuser according to one embodiment of the present disclosure.
Fig. 11 is a schematic view for a phase contrast which occurs in the light diffuser of Fig. 10.
Fig. 12 is a partial enlarged view of a light diffuser according to one embodiment of the present disclosure.
Fig. 13 is a schematic view for a phase contrast which occurs in the light diffuser of Fig. 12.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

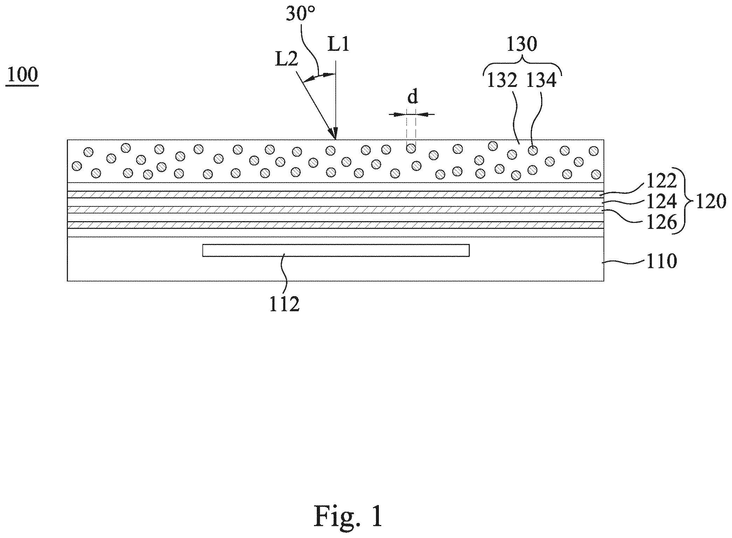

Fig. 1 is a cross-sectional view of an image sensor package 100 according to one embodiment of the present disclosure. The image sensor package 100 includes a semiconductor substrate 110 and a light diffuser 130. The semiconductor substrate 110 includes a photoelectric conversion region 112. The semiconductor substrate 110 may be a silicon wafer or chip, and the photoelectric conversion region 112 may include at least one photodiode. The light diffuser 130 is over the semiconductor substrate 110, and is configured to scatter incident light (e.g., light L1 or L2) to the underlying photoelectric conversion region 112 of the semiconductor substrate 110. The light diffuser 130 includes a main body 132 and a plurality of first fillers 134. In some embodiments, the main body 132 may be a photoresist layer including epoxy or acrylic resin. The first fillers 134 are uniformly dispersed in the main body 132, but not regularly arranged in the main body 132. The first fillers 134 include at least one of ZrO₂, Nb₂O₅, Ta₂O₅, SiₓN_{y}, Si, Ge GaP, InP, and PbS so as to have a high refractive index. For example, the refractive index of ZrO₂ is about 2.2. In some examples not falling under the scope of protection, ZrO₂, Nb₂O₅, Ta₂O₅, and SiₓN_{y} may be used to scatter visible light, while according to the invention, Si, Ge GaP, InP, and PbS are used to scatter infrared (IR). In addition, the diameter d of each of the first fillers 134 is in a range from 0.1 µm to 1 µm. If the diameter d of the first filler 134 is less than 0.1 µm, the scattering performance of light diffuser 130 would be unstable.

Since the first fillers 134 dispersed in the main body 132 of the light diffuser 130 have high refractive index, and the first fillers 134 include at least one of ZrO₂, Nb₂O₅, Ta₂O₅, SiₓN_{y}, Si, Ge GaP, InP, and PbS, the light diffuser 130 can have high scattering capability and prevent photolysis. Moreover, the first fillers 134 have low reactivity with organics, and thus the selection of materials for the main body 132 of the light diffuser 130 is more flexible. As a result, the main body 132 with the first fillers 134 may be formed over the semiconductor substrate 110 by spin coating without a compression molding process.

In some embodiments, there is no TiO₂ located in the main body 132 of the light diffuser 130 because TiO₂ has several disadvantages of strong photolysis, unstable scattering performance for low wavelength (e.g., smaller than 450 nm), high reactivity with organics, the acceleration effect of reaction (which is difficult to formulate photoresist), and high yellow index.

Furthermore, a refractive index of the first fillers 134 is higher than a refractive index of the main body 132. Larger difference between the refractive index of the first fillers 134 and the refractive index of the main body 132 may achieve better scattering performance of the light diffuser 130. For example, the refractive index of ZrO₂ (i.e., the first fillers 134) is about 2.2, and the refractive index of epoxy or acrylic resin (i.e., the main body 132) is about 1.5. In some embodiments, the weight ratio of the first fillers 134 to the light diffuser 130 (i.e., the combination of the main body 132 and the first fillers 134) is in a range from 10% to 30%. As a result of such a configuration, the light diffuser 130 may have good uniformity and intensity of illuminance during operation.

In some embodiments, the image sensor package 100 optionally includes a metal-insulator-metal (MIM) structure 120 between the light diffuser 130 and the semiconductor substrate 110. The MIM structure 120 includes a first metal layer 122, an insulating layer 124, and a second metal layer 126. The insulating layer 124 is between the first metal layer 122 and the second metal layer 126. The present disclosure is not limited to the number of metal layers and the number of insulating layers. The MIM structure 120 can narrow the full width at half maximum (FWHM) of light transmitted to the photoelectric conversion region 112, such that the image sensor package 100 can produce a high signal-to-noise (S/N) ratio. However, the MIM structure 120 has the issues of blue shift and angle dependence. The light diffuser 130 can help the image sensor package 100 to reduce a blue shift, and decrease the decay of the angular response at large angles of incidence.

In some embodiments, the light diffuser 130 is directly on or in contact with the MIM structure 120 or the semiconductor substrate 110 due to spin coating process. In the following description, a manufacturing method of the image sensor package 100 of Fig. 1 will be explained.

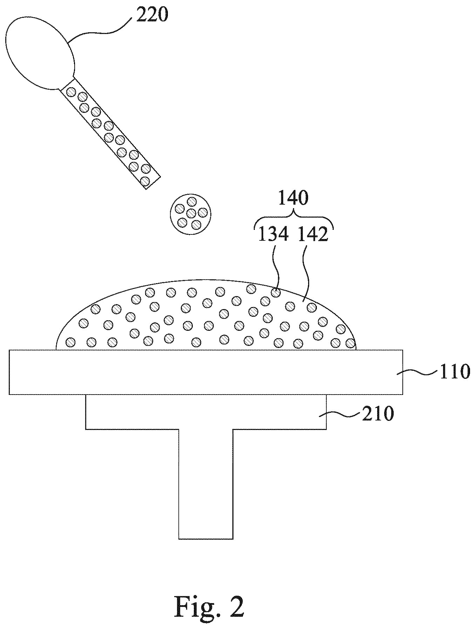

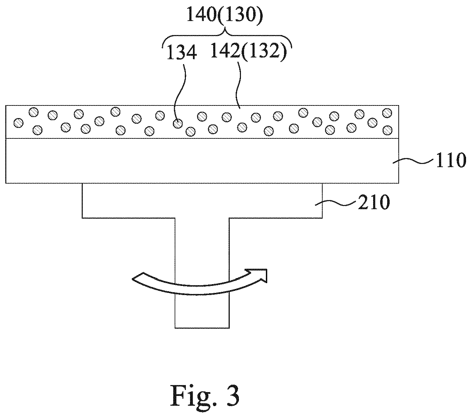

Figs. 2 and 3 are schematic views at various stages of a manufacturing method of the image sensor package 100 of Fig. 1. In order to simplify the drawings, the MIM structure 120 shown in Fig. 1 is omitted. Referring to Fig. 2, the manufacturing method of the image sensor package 100 includes mixing the first fillers 134 with a resin 142, such as epoxy or acrylic resin, to form a solution 140. The resin 142 may be referred to as a photoresist. The first fillers 134 include at least one of ZrO₂, Nb₂O₅, Ta₂O₅, SiₓN_{y}, Si, Ge GaP, InP, and PbS, and the diameter d (see Fig. 1) of each of the first fillers 134 is in a range from 0.1 µm to 1 µm. Thereafter, the solution 140 having the mixed resin 142 and the first fillers 134 is dispensed to the semiconductor substrate 110 on a wafer stage 210 by a dispenser 220.

As shown in Figs. 2 and 3, after the dispenser 220 drops the solution 140 over the semiconductor substrate 110, the wafer stage 210 may be rotated to spread the solution 140 such that the solution 140 covers the semiconductor substrate 100. The aforesaid process is spin coating. Afterwards, the solution 140 may be cured to form the light diffuser 130. In other words, the resin 142 is cured to be the main body 132 of the light diffuser 130.

It is to be noted that the connection relationships, materials, and advantages of the aforementioned elements will not be described again in the following description. In the following description, experimental results of the light diffuser during operation will be described.

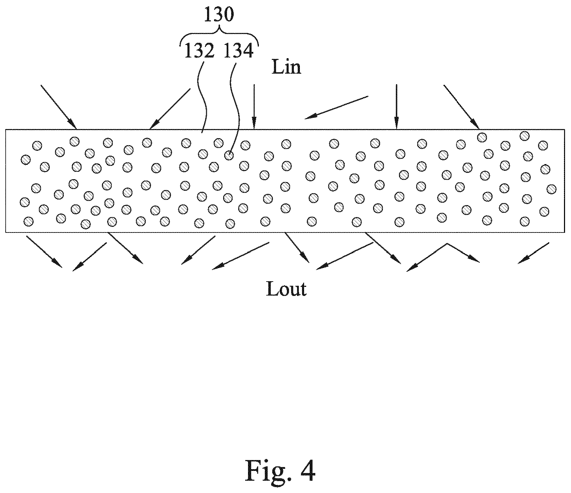

Fig. 4 is a schematic view of the light diffuser 130 when light passes through according to one embodiment of the present disclosure. As shown in Fig. 4, light Lin enters the top surface of the light diffuser 130, and then the first fillers 134 in the main body 132 can refract the light Lin, thereby forming scattering light Lout that irradiates from the bottom surface of the light diffuser 130. Due to the first fillers 134 in the main body 132, the scattering light Lout can be uniform and can maintain a desired luminous intensity.

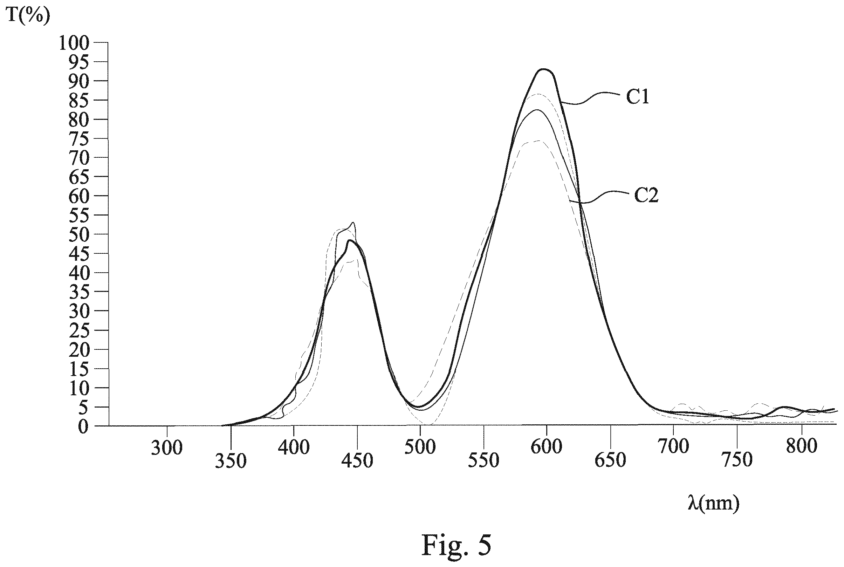

Fig. 5 is a Transmission rate-Wavelength relationship chart with respect to incident light with different incident angles passing through the light diffuser 130 of the image sensor package 100 of Fig. 1. As shown in Fig. 1 and Fig. 5, the incident light L1 vertically enters the light diffuser 130, and a curve C1 corresponding to different wavelengths of the incident light L1 with no incident angle is obtained. Moreover, the incident light L2 enters the light diffuser 130 with an incident angle 30 degrees, and a curve C2 corresponding to different wavelengths of the incident light L2 with the incident angle 30 degrees is obtained. Based on the data of the curves C1 and C2, differences between the curves C1 and C2 are mainly at wavelengths about 450 nm and about 600 nm. Although different incident angles affect the transmission rates of the light diffuser 130 at the tips of the curves C1 and C2, the distributions of the curves C1 and C2 are similar. That is, the light diffuser 130 has good scattering performance to improve the uniformity of light.

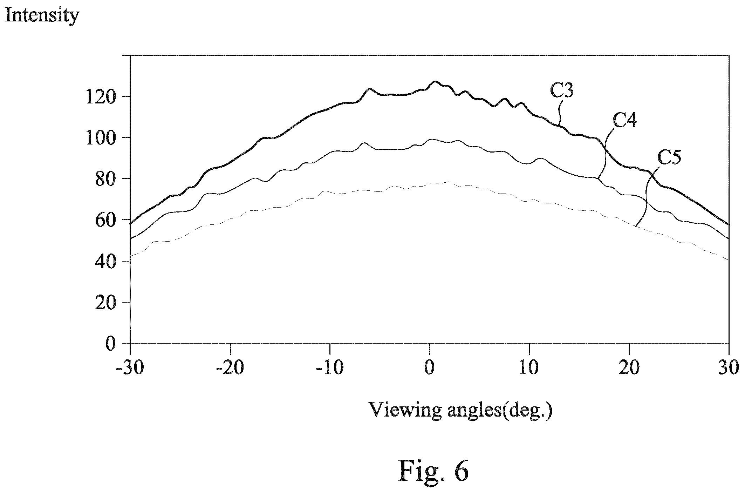

Fig. 6 is a Luminous intensity-Viewing angle relationship chart with respect to two light diffusers and one dry film, in which the two light diffusers include different proportions of fillers. As shown in Fig. 6, a curve C3 corresponds to a first light diffuser that includes a 20% weight ratio of fillers to the first light diffuser. In other words, the proportion by weight of the particles of the filler in the first light diffuser is 20%. A curve C4 corresponds to a second light diffuser that includes a 40% weight ratio of the fillers to the second light diffuser. In other words, the proportion by weight of the fillers in the second light diffuser is 40%. Furthermore, a curve C5 corresponds to a dry film, such as a diffuser sheet for bonding on a substrate.

According to the data of the curve C3, (Iₘₐₓ-Iₘᵢₙ)/Iₘₑₐₙ is about 75.3%, where Iₘₐₓ is the intensity value at 0 degree, Iₘᵢₙ is the intensity value at ±30 degrees, and Iₘₑₐₙ is (Iₘₐₓ+Iₘᵢₙ)/2. Based on the aforementioned formula, (Iₘₐₓ-Iₘᵢₙ)/Iₘₑₐₙ with respect to the curve C4 is about 62.5%, and (Iₘₐₓ₋Iₘᵢₙ)/Iₘₑₐₙ with respect to the curve C5 is about 62.2%. Accordingly, the weight ratio of the fillers can be increased to improve the uniformity of illuminance of the light diffuser.

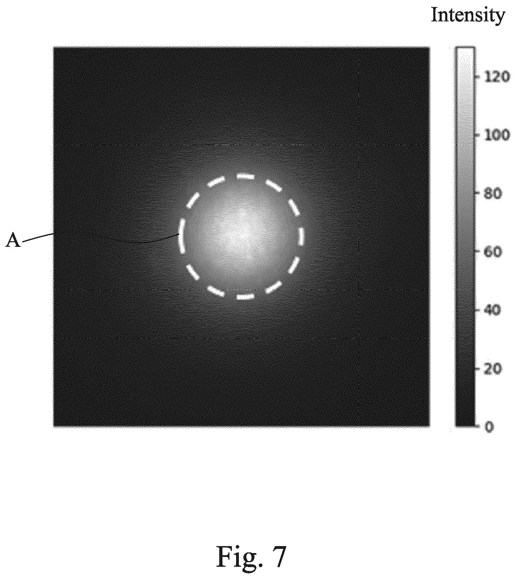

Fig. 7 is a distribution diagram of luminous intensity with respect to the light diffuser including a lower proportion of the fillers of Fig. 6 after light passing through the light diffuser. As shown in Fig. 6 and Fig. 7, the distribution diagram of the luminous intensity in Fig. 7 corresponds to the curve C3 of Fig. 6. That is, Fig. 7 is an experimental result with respect to the light passing through the first light diffuser that includes a 20% weight ratio of the fillers. An area A shown in Fig. 7 is defined by viewing angles in a range from +30 degrees to -30 degrees for the first light diffuser. The area A shows good luminous intensity of the first diffuser corresponding to the curve C3. The luminous intensity of the first diffuser is better than the luminous intensity of each of the second diffuser (corresponding to the curve C4) and the dry film (corresponding to the curve C5). Accordingly, although the weight ratio of the fillers can be increased to improve the uniformity of illuminance of the light diffuser, lower weight ratio of the fillers may maintain the luminous intensity of the light diffuser.

In some embodiments, the weight ratio of the first fillers (e.g., ZrO₂) to the light diffuser may be in a range from 10% to 30%. In some embodiments, the weight ratio of second fillers (e.g., SiO₂) to the light diffuser may be in a range from 20% to 50%. Based on the aforementioned ranges with respect to the weight ratio of the fillers, the light diffuser may have a balance between uniformity and intensity of illuminance.

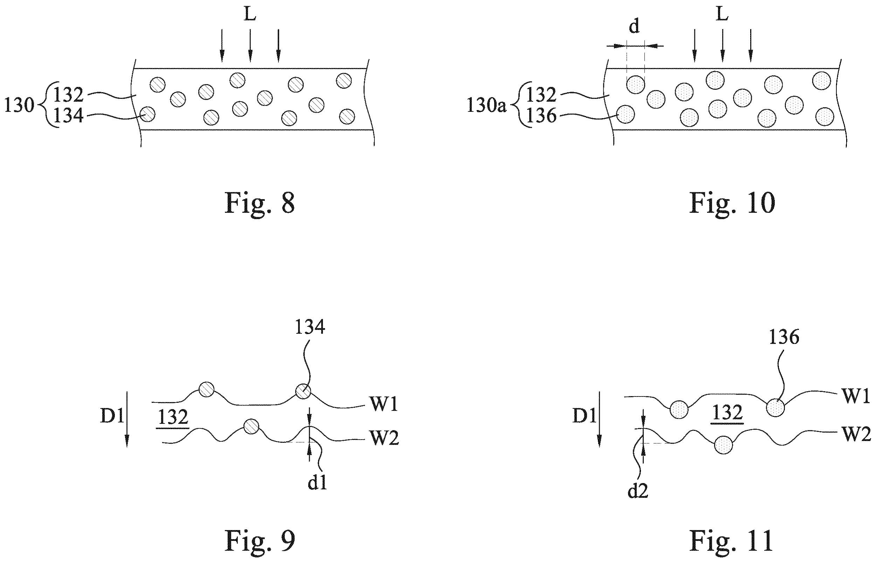

Fig. 8 is a partial enlarged view of the light diffuser 130 of Fig. 1. Fig. 9 is a schematic view for a phase contrast d1 which occurs in the light diffuser 130 of Fig. 8. As shown in Fig. 8 and Fig. 9, when light L enters the light diffuser 130, the light L is transmitted to the first fillers 134 in a direction D1. Phase contrast is dominated by nH/n0, where nH is the refractive index of the first fillers 134, and n0 is the refractive index of the main body 132 of the light diffuser 130. In some embodiments, the refractive index of the first fillers 134 (e.g., ZrO2) is about 2.2, and the refractive index of the main body 132 (e.g., epoxy resin) is about 1.5.

When the light L is transmitted to the first fillers 134 that the light L encounters first, a wave front W1 is formed because the first fillers 134 that the light L encounters first reduce the velocity of the light L. Thereafter, when the wave front W1 is transmitted to the first fillers 134 that the light L encounters later, a wave front W2 is formed because the first fillers 134 that the light L encounters later reduce the velocity of the wave front W1. As a result of such a configuration, the phase contrast d1 can be formed. The arrangement of the first fillers 134 in the main body 132 shown in Fig. 9 is merely an example, and the present disclosure is not limited in this regard.

Fig. 10 is a partial enlarged view of a light diffuser 130a according to one embodiment of the present disclosure. Fig. 11 is a schematic view for a phase contrast d2 which occurs in the light diffuser 130a of Fig. 10. As shown in Fig. 10 and Fig. 11, the light diffuser 130a includes a plurality of second fillers 136 uniformly dispersed in the main body 132. The second fillers 136 are not regularly arranged in the main body 132. The refractive index of the second fillers 136 is lower than the refractive index of the main body 132. In some embodiments, the second fillers 136 include SiO₂, and the diameter d of each of the second fillers 136 is in a range from 1 µm to 10 µm.

When the light L enters the light diffuser 130a, the light L is transmitted to the second fillers 136 in the direction D1. Phase contrast is dominated by n0/nL, where nL is the refractive index of the second fillers 136, and n0 is the refractive index of the main body 132 of the light diffuser 130a. In some embodiments, the refractive index of the second fillers 136 (e.g., SiO₂) is about 1.47, and the refractive index of the main body 132 (e.g., epoxy resin) is about 1.5.

When the light L is transmitted to the second fillers 136 that the light L encounters first, a wave front W1 is formed because the second fillers 136 that the light L encounters first increase the velocity of the light L. Thereafter, when the wave front W1 is transmitted to the second fillers 136 that the light L encounters later, a wave front W2 is formed because the second fillers 136 that the light L encounters later increase the velocity of the wave front W1. As a result of such a configuration, the phase contrast d2 can be formed. The arrangement of the second fillers 136 in the main body 132 shown in Fig. 11 is merely an example, and the present disclosure is not limited in this regard.

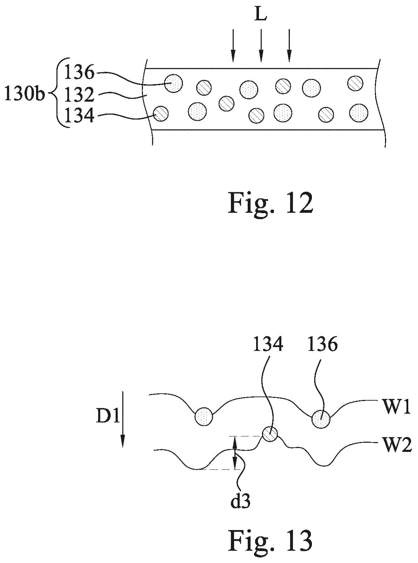

Fig. 12 is a partial enlarged view of a light diffuser 130b according to one embodiment of the present disclosure. Fig. 13 is a schematic view for a phase contrast d3 which occurs in the light diffuser 130b of Fig. 12. As shown in Fig. 12 and Fig. 13, the light diffuser 130b includes the main body 132, the first fillers 134 of Fig. 8, and the second fillers 136 of Fig. 10. The first fillers 134 and the second fillers 136 are mixed in the main body 132. The first fillers 134 and the second fillers 136 are uniformly dispersed in the main body 132 of the light diffuser 130b, but not regularly arranged in the main body 132. The refractive index of the second fillers 136 is lower than the refractive index of the first fillers 134, and is lower than the refractive index of the main body 132. In some embodiments, the weight ratio of the second fillers 136 to the light diffuser 130b (i.e., the combination of the main body 132, the first fillers 134, and the second fillers 136) is in a range from 20% to 50%.

When the light L enters the light diffuser 130b, the light L is transmitted to the second fillers 136 in the direction D1. Phase contrast is dominated by nH/nL, where nH is the refractive index of the first fillers 134, and nL is the refractive index of the second fillers 136. In some embodiments, the refractive index of the first fillers 134 (e.g., ZrO2) is about 2.2, and the refractive index of the second fillers 136 (e.g., SiO₂) is about 1.47.

When the light L is transmitted to the second fillers 136 that the light L encounters first, a wave front W1 is formed because the second fillers 136 that the light L encounters first increase the velocity of the light L. Thereafter, when the wave front W1 is transmitted to the first fillers 134 that the light L encounters later, a wave front W2 is formed because the first fillers 134 that the light L encounters later reduce the velocity of the wave front W1. As a result of such a configuration, the phase contrast d3 can be formed. The arrangement of the first fillers 134 and the second fillers 136 in the main body 132 shown in Fig. 13 is merely an example, and the present disclosure is not limited in this regard.

Referring back to Fig. 2, the manufacturing method of the light diffuser 130b further includes prior to dispensing the solution 140 to the semiconductor substrate 110, mixing second fillers 136 with the resin 142, wherein the refractive index of the second fillers 136 is lower than the refractive index of the first fillers 134. As a result, the solution 140 may include the first fillers 134 and the second fillers 136. Thereafter, the solution 140 may be cured to form the light diffuser 130b of Fig. 12.

## Claims

1. A light diffuser, comprising:
a main body (132); and
a plurality of first fillers (134) dispersed in the main body (132), wherein the first fillers (134) comprise at least one of Si, Ge GaP, InP, and PbS, and a diameter of each of the first fillers (134) is in a range from 0.1 µm to 1 µm.

2. The light diffuser of claim 1, wherein a refractive index of the first fillers (134) is higher than a refractive index of the main body (132).

3. The light diffuser of any one of claims 1-2, wherein a weight ratio of the first fillers (134) to a combination of the main body (132) and the first fillers (134) is in a range from 10% to 30%.

4. The light diffuser of claim 1, further comprising
a plurality of second fillers (136) dispersed in the main body (132), wherein a refractive index of the second fillers (136) is lower than a refractive index of the first fillers (134), and the refractive index of the second fillers (136) is lower than a refractive index of the main body (132).

5. The light diffuser of claim 4, wherein the second fillers (136) comprise SiO₂.

6. The light diffuser of any one of claims 4-5, wherein a diameter of each of the second fillers (136) is in a range from 1 µm to 10 µm.

7. The light diffuser of any one of claims 4-6, wherein a weight ratio of the second fillers (136) to a combination of the main body (132), the first fillers (134), and the second fillers (136) is in a range from 20% to 50%.

8. The light diffuser of any one of claims 4-7, wherein the main body (132) is a photoresist layer comprising epoxy or acrylic resin, and there is no TiO₂ located in the main body (132).

9. An image sensor package, comprising:
a semiconductor substrate (110) comprising a photoelectric conversion region (112); and
a light diffuser (130) over the semiconductor substrate (110) and configured to scatter incident light to the photoelectric conversion region (112), wherein the light diffuser (130) is the light diffuser of claim 1.

10. The image sensor package of claim 9, further comprising:
a metal-insulator-metal (MIM) structure (120) between the light diffuser (130) and the semiconductor substrate (110), wherein the light diffuser (130) is directly on the MIM structure (120).

11. The image sensor package of any one of claims 9-10, wherein a refractive index of the first fillers (134) is higher than a refractive index of the main body (132).

12. The image sensor package of claim 9, further comprising
a plurality of second fillers (136) dispersed in the main body (132), wherein a refractive index of the second fillers (136) is lower than a refractive index of the first fillers (134) and a refractive index of the main body (132).

13. The image sensor package of claim 12, wherein the second fillers (136) comprise SiO₂, a diameter of each of the second fillers (136) is in a range from 1 µm to 10 µm, and a weight ratio of the second fillers (136) to a combination of the main body (132), the first fillers (134), and the second fillers (136) is in a range from 20% to 50%.

14. A manufacturing method of an image sensor package, comprising:
mixing a plurality of first fillers (134) with a resin (142) to form a solution (140), wherein the first fillers (134) comprise at least one of Si, Ge GaP, InP, and PbS, and a diameter of each of the first fillers (134) is in a range from 0.1 µm to 1 µm;
dispensing the solution (140) to a semiconductor substrate (110);
spreading the solution (140) to cover the semiconductor substrate (110) by spin coating; and
curing the solution (140) to form a light diffuser (130), wherein the resin (142) is cured to be a main body (132) of the light diffuser (130).

15. The manufacturing method of the image sensor package of claim 14, further comprising:
prior to dispensing the solution (140) to the semiconductor substrate (110), mixing a plurality of second fillers (136) with the resin (142), wherein a refractive index of the second fillers (136) is lower than a refractive index of the first fillers (134).

## Patentansprüche

1. Lichtdiffusor, umfassend:
einen Hauptkörper (132); und
eine Vielzahl von ersten Füllstoffen (134), die im Hauptkörper (132) verteilt sind, wobei die ersten Füllstoffe (134) mindestens eines von Si, Ge GaP, InP und PbS umfassen und ein Durchmesser jedes der ersten Füllstoffe (134) in einem Bereich von 0,1 µm bis 1 µm liegt.

2. Lichtdiffusor nach Anspruch 1, wobei ein Brechungsindex der ersten Füllstoffe (134) höher ist als ein Brechungsindex des Hauptkörpers (132).

3. Lichtdiffusor nach einem der Ansprüche 1 bis 2, wobei ein Gewichtsverhältnis der ersten Füllstoffe (134) zu einer Kombination aus dem Hauptkörper (132) und den ersten Füllstoffen (134) in einem Bereich von 10 % bis 30 % liegt.

4. Lichtdiffusor nach Anspruch 1, ferner umfassend eine Vielzahl von zweiten Füllstoffen (136), die im Hauptkörper (132) verteilt sind, wobei ein Brechungsindex der zweiten Füllstoffe (136) niedriger ist als ein Brechungsindex der ersten Füllstoffe (134) und der Brechungsindex der zweiten Füllstoffe (136) niedriger ist als ein Brechungsindex des Hauptkörpers (132).

5. Lichtdiffusor nach Anspruch 4, wobei die zweiten Füllstoffe (136) SiO₂ umfassen.

6. Lichtdiffusor nach einem der Ansprüche 4 bis 5, wobei ein Durchmesser jedes der zweiten Füllstoffe (136) in einem Bereich von 1 µm bis 10 µm liegt.

7. Lichtdiffusor nach einem der Ansprüche 4 bis 6, wobei ein Gewichtsverhältnis der zweiten Füllstoffe (136) zu einer Kombination aus dem Hauptkörper (132), den ersten Füllstoffen (134) und den zweiten Füllstoffen (136) in einem Bereich von 20 % bis 50 % liegt.

8. Lichtdiffusor nach einem der Ansprüche 4 bis 7, wobei der Hauptkörper (132) eine Photolackschicht aus Epoxid- oder Acrylharz ist und sich im Hauptkörper (132) kein TiO₂ befindet.

9. Bildsensorgehäuse, umfassend:
ein Halbleitersubstrat (110), das einen photoelektrischen Umwandlungsbereich (112) umfasst; und
einen Lichtdiffusor (130) über dem Halbleitersubstrat (110), der so konfiguriert ist, dass er einfallendes Licht auf den photoelektrischen Umwandlungsbereich (112) streut, wobei der Lichtdiffusor (130) der Lichtdiffusor nach Anspruch 1 ist.

10. Bildsensorgehäuse nach Anspruch 9, ferner umfassend:
eine Metall-Isolator-Metall-Struktur (MIM) (120) zwischen dem Lichtdiffusor (130) und dem Halbleitersubstrat (110), wobei sich der Lichtdiffusor (130) direkt auf der MIM-Struktur (120) befindet.

11. Bildsensorgehäuse nach einem der Ansprüche 9 bis 10, wobei ein Brechungsindex der ersten Füllstoffe (134) höher ist als ein Brechungsindex des Hauptkörpers (132).

12. Bildsensorgehäuse nach Anspruch 9, das ferner eine Vielzahl von im Hauptkörper (132) verteilten zweiten Füllstoffen (136) umfasst, wobei ein Brechungsindex der zweiten Füllstoffe (136) niedriger ist als ein Brechungsindex der ersten Füllstoffe (134) und ein Brechungsindex des Hauptkörpers (132).

13. Bildsensorgehäuse nach Anspruch 12, wobei die zweiten Füllstoffe (136) SiO₂ umfassen, ein Durchmesser jedes der zweiten Füllstoffe (136) in einem Bereich von 1 µm bis 10 µm liegt und ein Gewichtsverhältnis der zweiten Füllstoffe (136) zu einer Kombination aus dem Hauptkörper (132), den ersten Füllstoffen (134) und den zweiten Füllstoffen (136) in einem Bereich von 20 % bis 50 % liegt.

14. Herstellungsverfahren eines Bildsensorgehäuses, umfassend:
Mischen einer Vielzahl von ersten Füllstoffen (134) mit einem Harz (142), um eine Lösung (140) zu bilden, wobei die ersten Füllstoffe (134) mindestens eines von Si, Ge GaP, InP und PbS umfassen und ein Durchmesser jedes der ersten Füllstoffe (134) in einem Bereich von 0,1 µm bis 1 µm liegt;
Verteilen der Lösung (140) auf einem Halbleitersubstrat (110);
Verbreiten der Lösung (140) zum Bedecken des Halbleitersubstrats (110) durch Schleuderbeschichtung; und
Aushärten der Lösung (140), um einen Lichtdiffusor (130) zu bilden, wobei das Harz (142) ausgehärtet wird, um einen Hauptkörper (132) des Lichtdiffusors (130) zu bilden.

15. Herstellungsverfahren eines Bildsensorgehäuses nach Anspruch 14, ferner umfassend:
vor dem Auftragen der Lösung (140) auf das Halbleitersubstrat (110), Mischen einer Vielzahl von zweiten Füllstoffen (136) mit dem Harz (142), wobei ein Brechungsindex der zweiten Füllstoffe (136) niedriger ist als ein Brechungsindex der ersten Füllstoffe (134).

## Revendications

1. Diffuseur de lumière, comprenant :
un corps principal (132) ; et
une pluralité de premières charges (134) dispersées dans le corps principal (132), dans lequel les premières charges (134) comprennent au moins l'un parmi Si, Ge GaP, InP et PbS, et un diamètre de chacune des premières charges (134) est compris dans une plage de 0,1 µm à 1 µm.

2. Diffuseur de lumière selon la revendication 1, dans lequel un indice de réfraction des premières charges (134) est supérieur à un indice de réfraction du corps principal (132).

3. Diffuseur de lumière selon l'une quelconque des revendications 1 et 2, dans lequel un rapport pondéral des premières charges (134) à une combinaison du corps principal (132) et des premières charges (134) est compris dans une plage de 10 % à 30 %.

4. Diffuseur de lumière selon la revendication 1, comprenant en outre une pluralité de secondes charges (136) dispersées dans le corps principal (132), dans lequel un indice de réfraction des secondes charges (136) est inférieur à un indice de réfraction des premières charges (134), et l'indice de réfraction des secondes charges (136) est inférieur à un indice de réfraction du corps principal (132).

5. Diffuseur de lumière selon la revendication 4, dans lequel les secondes charges (136) comprennent du SiO₂.

6. Diffuseur de lumière selon l'une quelconque des revendications 4 et 5, dans lequel un diamètre de chacune des secondes charges (136) est compris dans une plage de 1 µm à 10 µm.

7. Diffuseur de lumière selon l'une quelconque des revendications 4 à 6, dans lequel un rapport pondéral des secondes charges (136) à une combinaison du corps principal (132), des premières charges (134) et des secondes charges (136) est compris dans une plage de 20 % à 50 %.

8. Diffuseur de lumière selon l'une quelconque des revendications 4 à 7, dans lequel le corps principal (132) est une couche de résine photosensible comprenant une résine époxy ou acrylique, et il n'y a pas de TiO₂ situé dans le corps principal (132).

9. Boîtier de capteur d'image, comprenant :
un substrat semi-conducteur (110) comprenant une région de conversion photoélectrique (112) ; et
un diffuseur de lumière (130) sur le substrat semi-conducteur (110) et configuré pour diffuser une lumière incidente vers la région de conversion photoélectrique (112), dans lequel le diffuseur de lumière (130) est le diffuseur de lumière selon la revendication 1.

10. Boîtier de capteur d'image selon la revendication 9, comprenant en outre :
une structure métal-isolant-métal (MIM) (120) entre le diffuseur de lumière (130) et le substrat semi-conducteur (110), dans lequel le diffuseur de lumière (130) est directement sur la structure MIM (120).

11. Boîtier de capteur d'image selon l'une quelconque des revendications 9 et 10, dans lequel un indice de réfraction des premières charges (134) est supérieur à un indice de réfraction du corps principal (132).

12. Boîtier de capteur d'image selon la revendication 9, comprenant en outre une pluralité de secondes charges (136) dispersées dans le corps principal (132), dans lequel un indice de réfraction des secondes charges (136) est inférieur à un indice de réfraction des premières charges (134) et à un indice de réfraction du corps principal (132).

13. Boîtier de capteur d'image selon la revendication 12, dans lequel les secondes charges (136) comprennent du SiO₂, un diamètre de chacune des secondes charges (136) est compris dans une plage de 1 µm à 10 µm, et un rapport pondéral des secondes charges (136) à une combinaison du corps principal (132), des premières charges (134) et des secondes charges (136) est compris dans une plage de 20 % à 50 %.

14. Procédé de fabrication d'un boîtier de capteur d'image, comprenant :
le mélange d'une pluralité de premières charges (134) avec une résine (142) pour former une solution (140), dans lequel les premières charges (134) comprennent au moins l'un parmi Si, Ge GaP, InP et PbS, et un diamètre de chacune des premières charges (134) est compris dans une plage de 0,1 µm à 1 µm ;
la distribution de la solution (140) sur un substrat semi-conducteur (110) ;
l'étalement de la solution (140) pour recouvrir le substrat semi-conducteur (110) par revêtement par centrifugation ; et
le durcissement de la solution (140) pour former un diffuseur de lumière (130), dans lequel la résine (142) est durcie pour être un corps principal (132) du diffuseur de lumière (130).

15. Procédé de fabrication du boîtier de capteur d'image selon la revendication 14, comprenant en outre :
avant la distribution de la solution (140) sur le substrat semi-conducteur (110), le mélange d'une pluralité de secondes charges (136) avec la résine (142), dans lequel un indice de réfraction des secondes charges (136) est inférieur à un indice de réfraction des premières charges (134).
